(19) Europäisches Patentamt
European Patent Office
Office européen des brevets

(11) **EP 4 683 478 A1**

(12) **DEMANDE DE BREVET EUROPEEN**

(43) Date de publication:
**21.01.2026 Bulletin 2026/04**

(21) Numéro de dépôt: **25189559.5**

(22) Date de dépôt: **15.07.2025**

(51) Classification Internationale des Brevets (IPC):
*H10K 59/80* (2023.01)    *H10K 50/85* (2023.01)
*H10K 50/818* (2023.01)   *H10K 50/822* (2023.01)

(52) Classification Coopérative des Brevets (CPC):
**H10K 59/80515; H10K 59/80518; H10K 59/875**

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**GE KH LA MA MD TN**

(30) Priorité: **18.07.2024 FR 2407912**

(71) Demandeur: **Commissariat à l'Energie Atomique
et aux Energies
Alternatives
75015 Paris (FR)**

(72) Inventeurs:
• **LAUGIER, Christelle**
  **38054 Grenoble cedex 09 (FR)**
• **RACINE, Benoît**
  **38054 Grenoble cedex 09 (FR)**
• **ALTAZIN, Stéphane**
  **38054 Grenoble cedex 09 (FR)**

(74) Mandataire: **Germain Maureau
12, rue Boileau
69006 Lyon (FR)**

(54) **STRUCTURE DE SUPPORT ET DISPOSITIF OPTOÉLECTRONIQUE**

(57) L'invention concerne une structure de support (10) comprenant un dispositif électronique de commande (3) comprenant une électrode de commande (5) ; des motifs en relief (21) agencés sur l'électrode de commande (5), chacun des motifs en relief (21) étant séparé d'au moins un autre des motifs en relief (21) d'une distance (D) correspondant à un multiple entier d'un pas fixe (P) prédéterminé ; et une électrode structurée (30) métallique agencée de sorte à présenter des zones de contact (Zp) au niveau desquelles l'électrode structurée (30) est directement en contact avec l'électrode de commande (5), et des zones d'écartement (Ze) au niveau de chacune desquelles l'électrode structurée (30) est séparée de l'électrode de commande (5) par au moins un des motifs en relief (21).

L'invention concerne également un procédé de fabrication d'une telle structure de support (10), et un dispositif optoélectronique (1) comprenant une telle structure de support (10).

**Fig. 1**

EP 4 683 478 A1

## Description

### Domaine technique de l'invention

La présente invention concerne le domaine des dispositifs optoélectroniques notamment pour des applications nécessitant des hautes fréquences d'émissions lumineuse et/ou une forte luminance.

Plus particulièrement, l'invention concerne les diodes électroluminescentes, par exemple les diodes électroluminescentes organiques.

### Etat de la technique

Dans le domaine des télécommunications optiques, les besoins en rapidité de modulation des sources optiques sont de plus en plus importants. Il est demandé aux sources lumineuses d'avoir une bande passante dans un domaine de fréquence de plus en plus élevé. Cette augmentation de la fréquence ne doit cependant pas se faire au détriment de la luminance qui doit rester élevée pour conserver un bon niveau de transmission du signal.

Ces demandes sont un réel défi pour les dispositifs optoélectroniques et en particulier pour les diodes électroluminescentes organiques (ou OLED de l'anglais Organic Light-Emitting Diode). En effet, un des paramètres qui limite la bande passante est le temps de vie de fluorescence (correspondant au temps nécessaire à l'OLED pour émettre de la lumière). Ce temps, de l'ordre de quelques nanosecondes, dépend des caractéristiques intrinsèques des molécules responsables de la fluorescence. Ainsi, la bande passante des OLED serait limitée à quelques centaines de MHz.

Toutefois, il est connu de l'état de la technique qu'un effet, appelé « effet Purcell », permet de modifier le temps de vie de fluorescence d'une molécule en fonction de sa position dans l'empilement de l'OLED, et notamment de la distance séparant la couche émissive de l'une des électrodes de l'OLED. Il a notamment été montré que plus la distance entre la couche émissive et l'électrode était faible, plus le temps de vie de fluorescence était court.

Par ailleurs, la diminution du temps de vie radiatif d'un émetteur phosphorescent par effet Purcell permet d'augmenter la durée de vie (au sens de la dégradation) des dispositifs optoélectronique.

Toutefois, le rapprochement de la couche émissive à l'une des électrodes engendre un autre effet, souhaitable d'éviter habituellement, qui est de diminuer l'extraction de la lumière à cause du couplage plasmonique correspondant à l'excitation de plasmons à la surface des électrodes. Ces plasmons sont des modes guidés planaires totalement absorbés dans le plan du métal des électrodes au bout d'une certaine distance de propagation.

Afin d'extraire dans l'air la lumière guidée dans les modes plasmoniques, il est connu de l'état de la technique de structurer l'électrode.

Dans le cas des OLED, afin de limiter de potentiels court-circuits, il est connu de l'état de la technique de déposer une couche épaisse d'un matériau de transport de charge. Bien qu'une telle solution donne satisfaction en ce qu'elle permet à la fois de limiter les courts-circuits et d'extraire dans l'air la lumière guidée, l'utilisation d'une couche épaisse entre l'électrode et l'empilement comprenant la couche émissive conduit à éloigner ladite couche émissive de l'électrode, ce qui empêche donc d'obtenir l'effet Purcell souhaité.

Il existe donc un besoin de trouver une structure de support pour dispositif optoélectronique qui permette d'avoir une modulation rapide de l'émission lumineuse tout en conservant une luminance importante.

### Objet de l'invention

La présente invention a pour but de proposer une solution qui réponde à tout ou partie des problèmes précités.

Ce but peut être atteint grâce à la mise en oeuvre d'une structure de support pour supporter un empilement de couches semiconductrice, la structure de support comprenant :

- un dispositif électronique de commande comprenant une électrode de commande sensiblement plane et destinée à la transmission d'un signal électrique de commande à l'empilement, le dispositif électronique de commande étant configuré pour générer le signal électrique de commande ;
- des motifs en relief agencés sur l'électrode de commande, chacun des motifs en relief étant séparé d'au moins un autre des motifs en relief d'une distance correspondant à un multiple entier d'un pas fixe prédéterminé ; et
- une électrode structurée métallique d'un matériau différent des motifs en relief, ladite électrode structurée étant agencée de sorte à présenter des zones de contact au niveau desquelles l'électrode structurée est directement en contact avec l'électrode de commande, et des zones d'écartement au niveau de chacune desquelles l'électrode structurée est séparée de l'électrode de commande par au moins un des motifs en relief.

Les dispositions précédemment décrites permettent de proposer une structure de support apte à commander l'actionnement d'un dispositif optoélectronique par le dispositif électronique de commande, ce qui permet de réaliser une émission de lumière rapide et efficace.

En effet, la présence d'une électrode structurée permet d'extraire de la lumière liée à des modes d'émissions correspondant au pas fixe séparant les motifs en relief, tout en garantissant une continuité de l'électrode structurée en contact avec une couche électroluminescente du dispositif optoélectronique.

Il est donc bien compris que l'électrode de commande et l'électrode structurée sont connectée électriquement au niveau des zones de contact.

Il est également bien compris que l'électrode structurée est électriquement conductrice.

La structure de support peut en outre présenter une ou plusieurs des caractéristiques suivantes, prises seules ou en combinaison.

Selon un mode de réalisation, l'électrode structurée comprend de l'argent. Il a été constaté que l'utilisation d'un tel métal permettait de limiter l'absorption de plasmons dans l'électrode structurée et faciliter ainsi leur extraction.

Selon un mode de réalisation, l'électrode de commande est électriquement conductrice.

Selon un mode de réalisation, les motifs en relief sont électriquement isolants. Selon un mode de réalisation, les motifs en relief comprennent un matériau isolant.

Selon un mode de réalisation, l'électrode structurée présente une épaisseur sensiblement constante.

Selon un mode de réalisation, l'électrode de commande comprend une face de contact sur laquelle sont disposés les motifs en relief.

Selon un mode de réalisation, l'électrode structurée présente une face inférieure tournée vers la face de contact de l'électrode de commande, et une face supérieure opposée à la face inférieure.

Selon un mode de réalisation, une hauteur au niveau d'une des zones d'écartement est strictement supérieure à une hauteur au niveau d'une des zones de contact adjacente à ladite zone d'écartement, lesdites hauteurs étant mesurées entre la face de contact et la face supérieure, sensiblement perpendiculairement à la face de contact.

Ainsi, il est possible de garantir une structuration de la face supérieure de l'électrode structurée qui soit semblable à la structuration des motifs en relief.

Selon un mode de réalisation, les motifs en relief sont disposés de manière périodique sur l'électrode de commande selon une période correspondant à un même multiple entier du pas fixe prédéterminé.

Par exemple, les motifs en relief sont disposés périodiquement selon le pas fixe prédéterminé, le multiple entier étant alors égal à 1.

Ainsi, le dépôt des motifs en relief est plus simple à mettre en œuvre.

Selon un mode de réalisation, les motifs en relief sont identiques.

Selon un mode de réalisation, les motifs en relief sont arrondis.

En d'autres termes, les motifs en relief comprennent une surface arrondie tournée du côté opposé à la face de contact de l'électrode de commande, cette surface arrondie ne présentant pas d'arête saillante.

Ainsi, il est possible de limiter le risque de rupture de l'électrode structurée, notamment quand elle présente une épaisseur faible.

Selon un mode de réalisation, le dispositif électronique de commande comprend un transistor. Par exemple un transistor CMOS de l'anglais Complementary metal oxide semi-conductor.

Ainsi, il est possible de commander de manière rapide l'électrode structurée en faisant varier le signal électrique de commande, ce qui est particulièrement avantageux pour des applications à haute fréquence.

Selon un mode de réalisation, le transistor est disposé dans une couche interne de la structure de support et comprend une borne connectée électriquement à l'électrode de commande par l'intermédiaire d'un conduit (ou via) traversant au moins une partie d'une épaisseur de ladite couche interne.

Selon un mode de réalisation, chaque motif en relief présente une épaisseur maximale comptée transversalement à la face de contact de l'électrode de commande qui est comprise entre 50 nm et 250 nm.

Selon un mode de réalisation, chaque motif en relief présente une épaisseur maximale comptée transversalement à la face de contact de l'électrode de commande qui est comprise entre 10 nm et 250 nm, et plus particulièrement entre 30 nm et 100 nm.

De cette manière, il est possible de garantir que l'épaisseur des motifs en relief soit suffisamment faible pour ne pas créer de différence de marche trop importante entre les zones de contact et les zones d'écartement.

Selon un mode de réalisation, les motifs en relief comprennent des bosses et/ou des nervures bombées, de sorte que l'électrode structurée présente une face supérieure bosselées et/ou corruguée.

Ainsi, la production de la structure de support est simplifiée.

Le but de l'invention peut également être atteint grâce à la mise en oeuvre d'un dispositif optoélectronique comprenant :

- une structure de support telle que décrite précédemment ;
- un empilement de couches semi-conductrices disposées sur l'électrode structurée formant une première électrode, ledit empilement comprenant au moins une couche électroluminescente ; et
- une deuxième électrode disposée sur l'empilement ;

la première électrode et la deuxième électrode étant agencées pour permettre la propagation du signal électrique de commande au travers de l'empilement.

Ainsi, il est possible de proposer un dispositif optoélectronique dans lequel la structuration de l'électrode structurée permet de minimiser la distance séparant la couche électroluminescente de l'électrode structurée, tout en redirigeant hors du dispositif optoélectronique, la lumière initialement couplée aux plasmons.

Le dispositif optoélectronique peut en outre présenter une ou plusieurs des caractéristiques suivantes, prises seules ou en combinaison.

Selon un mode de réalisation, le pas fixe prédéterminé est sensiblement égal à une longueur d'onde d'émission de la couche électroluminescente.

Selon un mode de réalisation, le pas fixe prédéterminé est compris entre 200 nm et 800 nm.

Ainsi, il est possible de permettre l'excitation d'un mode plasmon localisé à ladite longueur d'onde d'émission. L'émission lumineuse est ainsi plus efficace.

Selon un mode de réalisation, l'empilement de couches semi-conductrices comprend des couches semi-conductrices organiques et au moins une couche électroluminescente organique.

Selon un mode de réalisation, une distance séparant la couche électroluminescente et l'électrode structurée est inférieure à 80 nm, et notamment sensiblement égale à 30 nm.

Ainsi, il est possible de maximiser l'effet Purcell, ce qui permet de diminuer le temps de vie des molécules présentes dans la couche électroluminescente, et notamment dans le cas de molécules fluorescentes.

Le but de l'invention peut également être atteint grâce à la mise en oeuvre d'un procédé de fabrication pour fabriquer une structure de support telle que décrite précédemment, ledit procédé de fabrication comprenant :

- une étape de mise à disposition dans laquelle le dispositif électronique de commande est mis à disposition ;
- une étape de dépôt initial dans laquelle au moins une couche primaire est déposée sur l'électrode de commande du dispositif électronique de commande ;
- une étape de formation de motifs en relief dans laquelle des portions de ladite au moins une couche primaire sont retirées de l'électrode de commande, lesdites portions présentant une largeur comptée dans un plan parallèle à l'électrode de commande, ladite largeur correspondant à un multiple entier d'un pas fixe prédéterminé, le retrait desdites portions formant par complémentarité, les motifs en relief ;
- une étape de dépôt d'électrode, dans laquelle l'électrode structurée est déposée sur les motifs en relief et sur l'électrode de commande.

Les dispositions précédemment décrites permettent de proposer un procédé de fabrication d'une structure de support adaptée pour commander l'actionnement d'un dispositif optoélectronique par un dispositif électronique de commande, en permettant une émission de lumière rapide et efficace.

Le procédé de fabrication peut en outre présenter une ou plusieurs des caractéristiques suivantes, prises seules ou en combinaison.

Selon un mode de réalisation, la couche primaire déposée lors de l'étape de dépôt initial comprend une résine, l'étape de formation de motifs en relief comprenant alors :

- une étape d'insolation, dans laquelle ladite résine est insolée à travers un masque d'insolation, et
- une étape de développement, dans laquelle les portions de la couche primaire sont retirées par développement dans un solvant de développement pour former par complémentarité les motifs en relief.

Ainsi, il est possible de définir les motifs en relief à une échelle micrométrique ou nanométrique.

Selon un mode de réalisation, l'étape de dépôt initial comprend le dépôt d'une couche isolante intercalaire sur l'électrode de commande puis d'une résine sur la couche isolante intercalaire, l'étape de formation de motifs en relief comprenant alors :

- une étape d'insolation dans laquelle ladite résine est insolée à travers un masque d'insolation,
- une étape de développement dans laquelle des portions de la résine sont retirées par développement dans un solvant de développement pour former par complémentarité des motifs en relief intermédiaires, et
- une étape de gravure dans laquelle la résine et la couche isolante intercalaire sont gravées pour former les motifs en relief.

Les dispositions précédemment décrites permettent de définir une méthode alternative pour former les motifs en relief à une échelle micrométrique ou nanométrique.

Selon un mode de réalisation, l'étape de formation de motifs en relief comprend une étape de fluage, mise en œuvre après l'étape de développement, dans laquelle la résine est soumise à un traitement thermique à une température de fluage, de manière à arrondir les motifs en relief ou les motifs en relief intermédiaires.

De cette manière, il est possible de former des motifs en relief arrondis qui limitent le risque de rupture de l'électrode structurée, notamment quand elle présente une épaisseur faible.

**Description sommaire des dessins**

D'autres aspects, buts, avantages et caractéristiques de l'invention apparaîtront mieux à la lecture de la description détaillée suivante de modes de réalisation préférés de celle-ci, donnée à titre d'exemple non limitatif, et faite en référence aux dessins annexés sur lesquels :

La figure 1 est une vue schématique en coupe d'une structure de support selon un mode de réalisation particulier de l'invention.
La figure 2 est une vue schématique en coupe d'un dispositif optoélectronique selon un mode de réalisation particulier de l'invention.
La figure 3 est une vue schématique vue du dessus d'une structure de support selon un mode de réalisation particulier de l'invention.

La figure 4 est une vue schématique vue du dessus d'une structure de support selon un mode de réalisation particulier de l'invention.

La figure 5 est une vue schématique d'un procédé de fabrication selon un mode de réalisation particulier de l'invention.

La figure 6 est une vue schématique d'un procédé de fabrication selon un mode de réalisation particulier de l'invention.

La figure 7 est une vue schématique d'un procédé de fabrication d'un dispositif optoélectronique selon un mode de réalisation particulier de l'invention.

**Description détaillée**

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux.

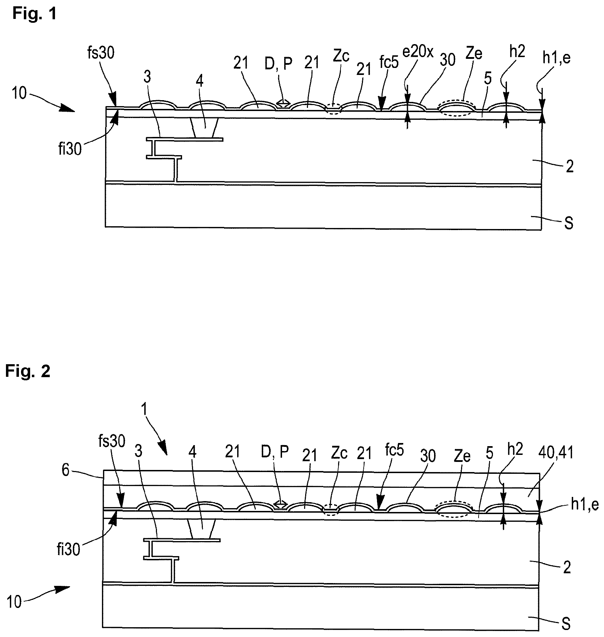

Comme cela est illustré sur les figures 1 à 4, l'invention concerne une structure de support 10 pour supporter un empilement 40 de couches semiconductrice. L'invention concerne également un dispositif optoélectronique 1 comprenant une telle structure de support 10 et un tel empilement 40.

Comme on peut le voir sur la figure 1, la structure de support 10 peut comprendre un substrat noté « S », notamment en verre ou en silicium, et comprend un dispositif électronique de commande 3. Le dispositif électronique de commande 3 comprend une électrode de commande 5 sensiblement plane, qui est destinée à la transmission d'un signal électrique de commande. Le dispositif électronique de commande 3 est configuré pour générer ledit signal électrique de commande. Par exemple, le dispositif électronique de commande 3 est configuré pour faire varier une tension électrique de commande appliquée à l'électrode de commande 5. L'électrode de commande 5 est généralement une électrode métallique qui est électriquement conductrice. Par exemple, l'électrode de commande 5 peut comprendre un matériau choisi parmi : l'argent, un alliage de cuivre-aluminium, le nitrure de titane, ou l'aluminium. Par « sensiblement plane », on entend que l'électrode de commande 5 présente une face de contact fc5, généralement tournée du côté opposé au substrat S qui ne présente pas de courbure. Généralement, la face de contact fc5 de l'électrode de commande présente une rugosité inférieure à 5 nm.

Pour commander l'électrode de commande 5, le dispositif électronique de commande 3 peut comprendre au moins un transistor, par exemple ayant une structure CMOS (de l'anglais Complementary metal oxide semi-conductor). L'utilisation d'un tel type de dispositif électronique de commande 3 permet de former un dispositif optoélectronique 1 ayant une grande rapidité de modulation d'émission lumineuse, ce qui est particulièrement avantageux pour les applications de télécommunications optiques.

Comme on peut le voir sur les figures 1 et 2, le dispositif électronique de commande 3 peut être disposé dans une couche interne 2 de la structure de support 10, et peut comprendre une borne connectée électriquement à l'électrode de commande 5 par l'intermédiaire d'un conduit 4 (ou via) traversant au moins une partie d'une épaisseur de ladite couche interne 2.

Des motifs en relief 21 sont agencés sur l'électrode de commande 5, au niveau de la face de contact fc5 de l'électrode de commande 5. Il en résulte que certaines portions de l'électrode de commande 5 ne sont pas recouvertes par des motifs en relief 21. Bien que cela ne soit pas limitatif, il est possible que les motifs en relief 21 comprennent un matériau isolant. Dans ce cas, les motifs en relief 21 sont électriquement isolants.

Chaque motif en relief 21 est séparé d'au moins un autre des motifs en relief 21 d'une distance notée « D » correspondant à un multiple entier d'un pas fixe noté « P » prédéterminé. Sur les figures, la distance D représentée est égale au pas fixe P, c'est-à-dire que le multiple entier est égal à 1. Toutefois, une telle construction n'est pas limitative, et il est tout à fait possible que le multiple entier soit supérieur à 1. Par exemple, le pas fixe P prédéterminé est compris entre 200 nm et 800 nm

De manière avantageuse, et comme cela est représenté sur les figures 1 à 4, il est possible que les motifs en relief 21 soient disposés de manière périodique sur l'électrode de commande 5 selon une période correspondant à un même multiple entier du pas fixe P prédéterminé. Par exemple, les motifs en relief 21 peuvent être disposés périodiquement selon le pas fixe P prédéterminé. Ainsi, le dépôt des motifs en relief 21 est plus simple à mettre en oeuvre. Par ailleurs, il est possible que les motifs en relief 21 soient tous identiques.

Les motifs en relief 21 peuvent présenter une surface externe tournée du côté opposé à l'électrode de commande 5 qui est arrondie. En d'autres termes, ladite surface externe ne présente pas d'arête saillante. Ainsi, il est possible de limiter le risque de rupture d'une électrode structurée 30 déposée sur les motifs en relief 21, qui sera décrite plus loin.

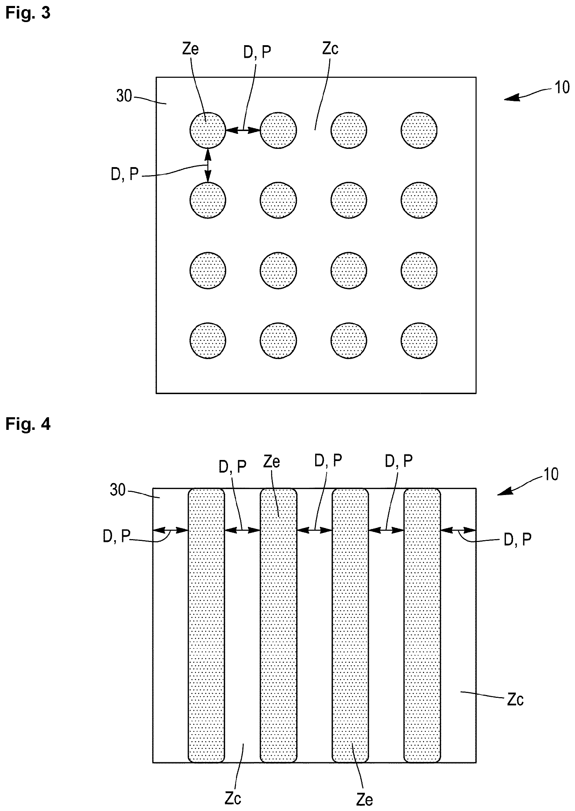

Les figures 3 et 4 illustrent deux variantes non limitatives de structures de support 10 dans laquelle les motifs en relief 21 comprennent des bosses (figure 3) ou des nervures bombées (figure 4). Il est cependant possible de combiner ces deux types de motifs entre eux, ou avec d'autres motifs équivalents.

La structure de support 10 comprend enfin une électrode structurée 30, généralement disposée sur les motifs en relief 21 et sur l'électrode de commande 5. L'électrode structurée 30 est métallique et d'un matériau différent des motifs en relief 21. Par exemple, l'électrode structurée 30 comprend l'oxyde d'indium-étain (ITO), de l'aluminium (Al), ou équivalent.

L'électrode structurée 30 est agencée de sorte à présenter des zones de contact Zp au niveau desquelles l'électrode structurée 30 est directement en contact avec l'électrode de commande 5, et des zones d'écartement Ze au niveau de chacune desquelles l'électrode structurée 30 est séparée de l'électrode de commande 5 par au moins un des motifs en relief 21. L'électrode structurée 30 est donc conductrice électriquement. Par exemple, l'électrode structurée 30 comprend ou est constituée d'argent. Ainsi, l'extraction des plasmons est facilitée car ils sont moins facilement absorbés dans l'électrode structurée 30. De manière générale, l'électrode structurée 30 est continue, notamment continue électriquement. On entend par cela que l'électrode structurée 30 présente sensiblement le même potentiel électrique sur toute son étendue.

Par « structurée » on entend que l'électrode structurée 30 présente au moins une surface non plane (en l'absence de matériau de remplissage) qui délimite un ensemble de reliefs correspondant aux motifs en relief 21. Les variantes des figures 3 et 4 illustrent respectivement des modes de réalisation dans lesquels l'électrode structurée 30 présente une face supérieure fs30 bosselée ou corruguée. Ainsi, la production de la structure de support 10 est simplifiée.

Comme indiqué précédemment, et comme on peut le voir notamment sur les figures 1 et 2, l'électrode structurée 30 est disjointe de l'électrode de commande 5 au niveau des zones d'écartement Ze. En effet, les motifs en relief 21 sont disposés entre l'électrode de commande 5 et l'électrode structurée 30 au niveau des zones d'écartement Ze.

A l'inverse, au niveau des zones de contact Zp, l'électrode de commande 5 et l'électrode structurée 30 sont connectées électriquement. Généralement, l'électrode de commande 5 et l'électrode structurée 30 sont en contact direct au niveau des zones de contact Zp.

L'électrode structurée 30 peut présenter une face inférieure fi30 tournée vers la face de contact fc5 de l'électrode de commande 5, qui est opposée à la face supérieure fs30. Dans ce cas, il est avantageux de prévoir qu'une hauteur h2 au niveau d'une des zones d'écartement Ze soit strictement supérieure à une hauteur h1 au niveau d'une des zones de contact Zp adjacente à ladite zone d'écartement Ze, lesdites hauteurs h1, h2 étant mesurées entre la face de contact fc5 et la face supérieure fs30 et sensiblement perpendiculairement à la face de contact fc5. Ainsi, il est possible de garantir une structuration de la face supérieure fs30 de l'électrode structurée 30 qui soit semblable à la structuration des motifs en relief 21.

Selon un mode de réalisation non limitatif, l'électrode structurée 30 peut présenter une épaisseur notée « e » sensiblement constante. Par exemple, l'épaisseur e de l'électrode structurée 30 est comprise entre 15 nm et 50 nm. Ainsi, il est possible de garantir une structuration de l'électrode structurée 30 semblable à la structuration des motifs en relief 21.

Chaque motif en relief 21 peut présenter une épaisseur maximale e20x comptée transversalement à la face de contact fc5 de l'électrode de commande 5 comprise entre 10 nm et 250 nm, et notamment entre 30nm et 100nm. De cette manière, il est possible de garantir que l'épaisseur des motifs en relief soit suffisamment faible pour ne pas créer de différence de marche trop importante entre les zones de contact Zp et les zones d'écartement Ze.

L'ensemble des dispositions précédemment décrites permettent de proposer une structure de support 10 apte à commander l'actionnement d'un dispositif optoélectronique 1 par un dispositif électronique de commande 3, ce qui permet de réaliser une émission de lumière rapide et efficace.

En effet, la présence d'une électrode structurée 30 permet d'extraire de la lumière liée à des modes d'émissions particuliers, et la valeur du pas fixe P séparant les motifs en relief 21 permet de diriger la lumière ainsi extraite selon une direction privilégiée. Par ailleurs, il est possible de garantir une continuité de l'électrode structurée 30 en contact avec une couche électroluminescente 41 du dispositif optoélectronique.

Comme indiqué ci-avant, l'invention concerne également un dispositif optoélectronique 1 dont un mode de réalisation est représenté sur la figure 2. Ce dispositif optoélectronique 1 comprend une structure de support 10 du type d'un de ceux décrits précédemment, et un empilement 40 de couches semi-conductrices disposées sur l'électrode structurée 30 qui forme une première électrode. L'empilement 40 comprend au moins une couche électroluminescente 41 configurée pour émettre un rayonnement lumineux autour d'une longueur d'onde prédéterminée. Par exemple ladite longueur d'onde prédéterminée est comprise entre 400 nm et 1000 nm.

Bien que cela ne soit pas limitatif, l'empilement 40 de couches semi-conductrices peut comprendre des couches semi-conductrices organiques et au moins une couche électroluminescente 41 organique.

De manière avantageuse, le pas fixe P prédéterminé peut être choisi pour orienter la lumière extraite par l'électrode structurée selon une direction privilégiée. Pour cela, il est possible de choisir le pas P en fonction de l'indice effectif du mode plasmon $n_{eff}$, du sinus de l'angle d'émission $\theta$, de la longueur d'onde d'émission $\lambda$ de la couche électroluminescente 41, et selon la formule suivante :

$$\sin(\theta) = \frac{n_{eff}}{\lambda} + \frac{K}{P}$$

, où K est un nombre entier. Par exemple, le pas fixe prédéterminé P peut être sensiblement égal à la longueur d'onde d'émission de la couche électroluminescente 41. De manière générale, l'indice effectif du mode plasmon $n_{eff}$ est compris entre 1,5 et 2. L'ensemble des dispositions précédemment décrites rendent possible l'excitation d'un mode plasmon localisé à ladite longueur d'onde d'émission. L'émission lumineuse est ainsi plus efficace.

Par ailleurs, une distance séparant la couche électroluminescente 41 de l'électrode structurée 30 peut être choisie inférieure à 80 nm, et notamment sensiblement égale à 30 nm. Ainsi, il est possible de maximiser l'effet Purcell, ce qui permet d'améliorer le temps de vie des molécules présentes dans la couche électroluminescente 41, et notamment dans le cas de molécules fluorescentes.

De manière synergique, l'utilisation d'un pas fixe prédéterminé P sensiblement égal à la longueur d'onde d'émission de la couche électroluminescente 41, tout en plaçant cette couche électroluminescente 41 à une distance inférieure à 80 nm, et notamment sensiblement égale à 30 nm permet à la fois de rendre possible l'excitation d'un mode plasmon et de maximiser l'effet Purcell qui sont deux effet a priori antagonistes.

Enfin, le dispositif optoélectronique 1 comprend une deuxième électrode 6, généralement au moins partiellement transparente, et disposée sur une surface dudit empilement 40 généralement opposée à l'électrode structurée 30. De cette manière, l'électrode structurée 30 et la deuxième électrode 6 sont configurée pour appliquer une tension électrique à l'empilement 40 de couches semi-conductrices, pour permettre notamment l'émission lumineuse par la couche électroluminescente 21. En d'autres termes, la première électrode et la deuxième électrode 6 sont agencées pour permettre la propagation du signal électrique de commande au travers de l'empilement 40.

L'ensemble des dispositions précédemment décrites permettent de proposer un dispositif optoélectronique 1 dans lequel la structuration de l'électrode structurée 30 permet de minimiser la distance D séparant la couche électroluminescente 41 de l'électrode structurée 30, tout en limitant l'absorption par couplage plasmonique.

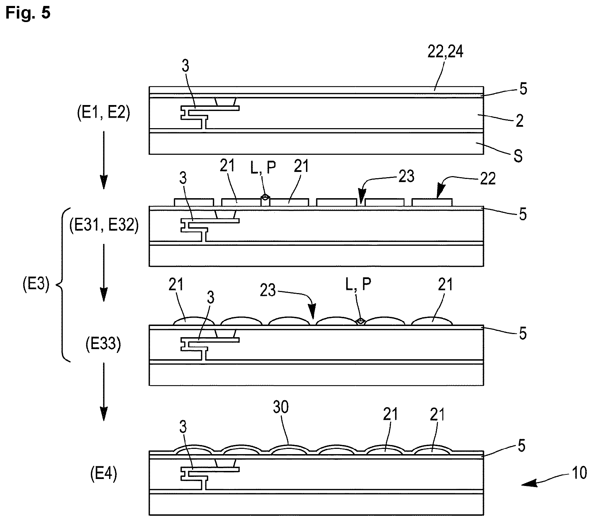

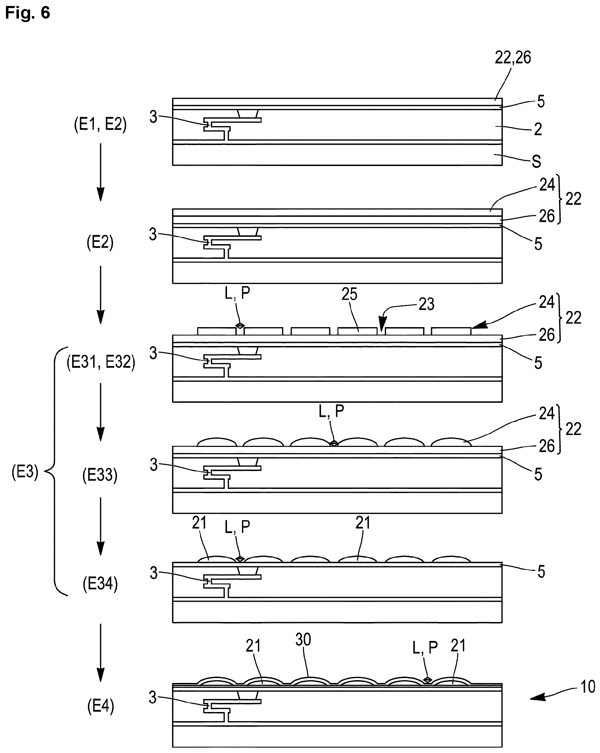

L'invention concerne également un procédé de fabrication d'une structure de support 10 telle que décrite précédemment, dont deux modes de réalisation sont présentés sur les figures 5 et 6.

Quel que soit le mode de réalisation, le procédé de fabrication comprend tout d'abord une étape de mise à disposition E1 dans laquelle le dispositif électronique de commande 3 est mis à disposition. Généralement, le dispositif électronique de commande 3 est encapsulé dans la couche interne 2, elle-même déposée sur le substrat S.

Le procédé de fabrication comprend ensuite une étape de dépôt initial E2 dans laquelle au moins une couche primaire 22 est déposée sur l'électrode de commande 5 du dispositif électronique de commande 3.

Selon le mode de réalisation illustré sur la figure 5, cette étape de dépôt initial E2 comprend le dépôt d'une résine 24, formant ainsi la couche primaire 22.

Selon le mode de réalisation illustré sur la figure 6, l'étape de dépôt initial E2 comprend le dépôt d'une couche isolante intercalaire 26 sur l'électrode de commande 5 puis d'une résine 24 sur la couche isolante intercalaire 26. La couche primaire 22 est ainsi formée par la superposition de la couche isolante intercalaire 26, et de la couche de résine 24. Dans ce cas, la couche primaire 22 est électriquement isolante.

Le procédé de fabrication comprend ensuite une étape de formation de motifs en relief E3 dans laquelle des portions 23 de ladite au moins une couche primaire 22 sont retirées de l'électrode de commande 5. Les portions 23 ainsi formées présentent une largeur L comptée dans un plan parallèle à l'électrode de commande 5 correspondant à un multiple entier du pas fixe P prédéterminé. Le retrait desdites portions 23 forme ainsi par complémentarité, les motifs en relief 21.

Selon le mode de réalisation de la figure 5, l'étape de formation de motifs en relief E3 comprend :

- une étape d'insolation E31, dans laquelle ladite résine 24 est insolée à travers un masque d'insolation, et
- une étape de développement E32, dans laquelle les portions 23 de la couche primaire 22 sont retirées par développement dans un solvant de développement pour former par complémentarité les motifs en relief 21.

Alternativement, et comme représenté sur la figure 6, l'étape de formation de motifs en relief E3 peut comprendre :

- une étape d'insolation E31 dans laquelle ladite résine 24 est insolée à travers un masque d'insolation,
- une étape de développement E32 dans laquelle des portions 23 de la résine 24 sont retirées par développement dans un solvant de développement pour former par complémentarité des motifs en relief intermédiaires 25, et
- une étape de gravure E34 dans laquelle la résine 24 et la couche isolante intercalaire 26 sont gravées, par gravure sèche ou humide, pour former les motifs en relief 21.

De telles étapes de formation de motifs en relief E3 correspondent à des procédés de photolithographie utilisé dans les procédés microélectroniques. Il est donc bien compris que suivant l'application visée, l'homme du métier choisira les résines, les masques d'insolation, et les solvants pour retirer par développement les portions de la couche primaire 22.

Les dispositions précédemment décrites permettent de définir deux méthodes alternative pour former les motifs en relief 21 à une échelle micrométrique ou nanométrique.

De manière avantageuse, l'étape de formation de motifs en relief E3 peut comprendre une étape de fluage E33, mise en œuvre après l'étape de développement E32. Lors de cette étape de fluage E33, la résine 24 est soumise à un traitement thermique à une température de fluage, de manière à arrondir les motifs en relief 21 ou les motifs en relief intermédiaires 25. De cette manière, il est possible de former des motifs en relief 21 arrondis qui limitent le risque de rupture de l'électrode structurée 30, notamment quand elle présente une épaisseur e faible. Il est donc bien compris que la formation de motifs en relief arrondis est particulièrement aisée en utilisant le fluage d'une résine.

Selon le mode de réalisation de la figure 6, l'étape de fluage E33 est mise en oeuvre entre l'étape de développement E32 et l'étape de gravure E34.

Enfin, le procédé de fabrication comprend une étape de dépôt d'électrode E4, dans laquelle l'électrode structurée 30 est déposée sur les motifs en relief et sur l'électrode de commande 5. De manière générale, un tel dépôt est réalisé en déposant un métal par un procédé choisi parmi le dépôt chimique en phase vapeur (ou CVD de l'anglais Chemical Vapor Deposition), le dépôt chimique en phase vapeur assisté par plasma (ou PECVD de l'anglais Plasma Enhanced Chemical Vapor Deposition), la pulvérisation cathodique (ou sputtering en anglais), le dépôt physique par phase vapeur (ou PVD de l'anglais Physical Vapor Deposition), le dépôt par ablation laser pulsée (ou PLD de l'anglais Pulsed Laser assisted Deposition), ledit métal formant l'électrode structurée 30 en se conformant à la structure formée par les motifs en relief 21 sur l'électrode de commande 5.

Les dispositions précédemment décrites permettent de proposer un procédé de fabrication d'une structure de support 10 adaptée pour commander l'actionnement d'un dispositif optoélectronique 1 par un dispositif électronique de commande 3, en permettant une émission de lumière rapide et efficace.

L'invention concerne également un procédé de fabrication d'un dispositif optoélectronique 1 tel que décrit précédemment. Ce procédé de fabrication comprend l'ensemble des étapes du procédé de fabrication d'une structure de support 10 décrit précédemment en référence aux figures 5 et 6.

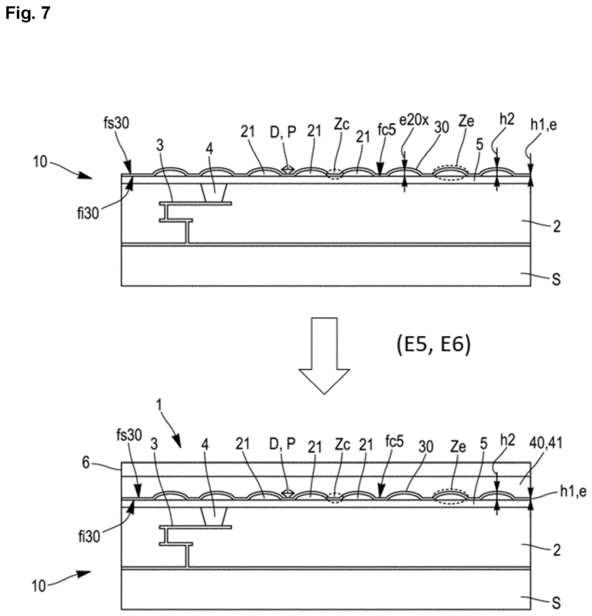

Ce procédé de fabrication d'un dispositif optoélectronique comprend également les étapes suivantes, illustrées sur la figure 7 :

- une étape de dépôt d'un empilement E5, dans laquelle un empilement 40 de couches semi-conductrices est déposé sur l'électrode structurée 30, ledit empilement 40 comprenant au moins une couche électroluminescente 41, le dépôt de la couche électroluminescente 41 lors de ladite étape de dépôt d'un empilement E5 étant réalisé de sorte qu'une distance séparant la couche électroluminescente 41 et l'électrode structurée 30 est inférieure à 80 nm, et notamment sensiblement égale à 30 nm ;
- une deuxième étape de dépôt d'électrode E6, dans laquelle une deuxième électrode 6 est déposée sur l'empilement 40.

Le procédé de fabrication du dispositif optoélectronique 1 comprend le fait que lors de l'étape de formation de motifs en relief E3, le pas fixe P prédéterminé est sensiblement égal à une longueur d'onde d'émission de la couche électroluminescente 41.

Par exemple, l'étape de dépôt d'un empilement E5 peut être réalisée par évaporation thermique. Dans ce cas, chaque couche de l'empilement 40 est déposé par évaporation du matériau correspondant à ladite couche. Pour cela, le matériau se trouve dans un creuset qui est chauffé par effet joule, afin d'atteindre la température d'évaporation du matériau, par exemple organique.

Chaque couche a une fonction bien particulière dans l'empilement 40 grâce à ses propriétés opto-électroniques.

Par exemple, l'empilement 40 peut comprendre l'empilement des couches suivantes : HIL/HTL/EBL/EL/HBL/ETL/EIL.

Avec :

- HIL pour Hole Injection Layer, par exemple le trioxyde de molybdène ($MoO_3$) ;
- HTL pour Hole Transporting Layer, par exemple le STTB ;
- EBL pour Electron Bloking Layer, par exemple le NPB ;
- EL pour la couche électroluminescente 41, par exemple Alq3 dopé ou non dopé ;
- HBL pour Hole Blocking Layer, par exemple le BCP ;
- ETL pour Electron Transporting Layer, par exemple le Bphen ;
- EIL pour Electron Injection Layer, par exemple un élément métallique.

Lors de la deuxième étape de dépôt d'électrode E6, il est possible que la deuxième électrode 6 comprenne de l'aluminium (Al) ou de l'argent (Ag), ou équivalent.

De manière générale, le procédé de fabrication peut comprendre une étape de dépôt d'une couche d'encapsulation (non représentée), par exemple une couche d'$Al_2O_3$, par exemple déposée par une technique ALD (Atomic Layer Deposition) »

## Revendications

1. Dispositif optoélectronique (1) comprenant :

   - une structure de support (10) comprenant :

       • un dispositif électronique de commande (3) comprenant une électrode de commande (5) sensiblement plane et destinée à la transmission d'un signal électrique de commande à l'empilement (40), le dispositif électronique de commande (3) étant configuré pour générer le signal électrique de commande ;
       • des motifs en relief (21) agencés sur l'électrode de commande (5), chacun des motifs en relief (21) étant séparé d'au moins un autre des motifs en relief (21) d'une distance (D) correspondant à un multiple entier d'un pas fixe (P) prédéterminé ; et
• une électrode structurée (30) métallique d'un matériau différent des motifs en relief (21), ladite électrode structurée (30) étant agencée de sorte à présenter des zones de contact (Zp) au niveau desquelles l'électrode structurée (30) est directement en contact avec l'électrode de commande (5), et des zones d'écartement (Ze) au niveau de chacune desquelles l'électrode structurée (30) est séparée de l'électrode de commande (5) par au moins un des motifs en relief (21) ;

- un empilement (40) de couches semi-conductrices disposées sur l'électrode structurée (30) formant une première électrode, ledit empilement (40) comprenant au moins une couche électroluminescente (41) ; et
- une deuxième électrode (6) disposée sur l'empilement (40) ;

la première électrode et la deuxième électrode (6) étant agencées pour permettre la propagation du signal électrique de commande au travers de l'empilement (40) ; dispositif optoélectronique (1) dans lequel ledit pas fixe (P) prédéterminé est sensiblement égal à une longueur d'onde d'émission de la couche électroluminescente (41), et dans lequel une distance séparant la couche électroluminescente (41) et l'électrode structurée (30) est inférieure à 80 nm, et notamment sensiblement égale à 30 nm.

2. Dispositif optoélectronique (1) selon la revendication 1, dans laquelle les motifs en relief (21) comprennent un matériau isolant.

3. Dispositif optoélectronique (1) selon l'une quelconque des revendications 1 ou 2, dans laquelle les motifs en relief (21) sont disposés de manière périodique sur l'électrode de commande (5) selon une période correspondant à un même multiple entier du pas fixe (P) prédéterminé.

4. Dispositif optoélectronique (1) selon l'une quelconque des revendications 1 à 3, dans laquelle les motifs en relief (21) sont arrondis.

5. Dispositif optoélectronique (1) selon l'une quelconque des revendications 1 à 4, dans laquelle le dispositif électronique de commande (3) comprend un transistor.

6. Dispositif optoélectronique (1) selon l'une quelconque des revendications 1 à 5, dans laquelle chaque motif en relief (21) présente une épaisseur maximale (e20x) comptée transversalement à la face de contact (fc5) de l'électrode de commande (5) qui est comprise entre 50 nm et 250 nm.

7. Dispositif optoélectronique (1) selon l'une quelconque des revendications 1 à 6, dans laquelle les motifs en relief (21) comprennent des bosses et/ou des nervures bombées, de sorte que l'électrode structurée (30) présente une face supérieure (fs30) bosselées et/ou corruguée.

8. Dispositif optoélectronique (1) selon la revendication 7, dans lequel l'empilement (40) de couches semi-conductrices comprend des couches semi-conductrices organiques et au moins une couche électroluminescente (41) organique.

9. Dispositif optoélectronique (1) selon l'une quelconque des revendications 8 à 10, dans lequel une distance séparant la couche électroluminescente (41) et l'électrode structurée (30) est inférieure à 80 nm, et notamment sensiblement égale à 30 nm.

10. Procédé de fabrication d'un dispositif optoélectronique (1) selon l'une quelconque des revendications 1 à 9, ledit procédé de fabrication comprenant :

- une étape de mise à disposition (E1) dans laquelle le dispositif électronique de commande (3) est mis à disposition ;
- une étape de dépôt initial (E2) dans laquelle au moins une couche primaire (22) est déposée sur l'électrode de commande (5) du dispositif électronique de commande (3) ;
- une étape de formation de motifs en relief (E3) dans laquelle des portions (23) de ladite au moins une couche primaire (22) sont retirées de l'électrode de commande (5), lesdites portions (23) présentant une largeur (L) comptée dans un plan parallèle à l'électrode de commande (5), ladite largeur (L) correspondant à un multiple entier d'un pas fixe (P) prédéterminé, le retrait desdites portions (23) formant par complémentarité, les motifs en relief (21) ;
- une première étape de dépôt d'électrode (E4), dans laquelle l'électrode structurée (30) est déposée sur les motifs en relief (21) et sur l'électrode de commande (5) ;
- une étape de dépôt d'un empilement (E5), dans laquelle un empilement (40) de couches semi-conductrices est déposé sur l'électrode structurée (30), ledit empilement (40) comprenant au moins une couche électroluminescente (41), le dépôt de la couche électroluminescente (41) lors de ladite étape de dépôt d'un empilement (E5) étant réalisé de sorte qu'une distance séparant la couche électroluminescente (41) et l'électrode structurée (30) est inférieure à 80 nm, et notamment sensiblement égale à 30 nm ;
- une deuxième étape de dépôt d'électrode (E6), dans laquelle une deuxième électrode (6) est déposée sur l'empilement (40) ;

le procédé de fabrication étant **caractérisé en ce que** lors de l'étape de formation de motifs en relief (E3), le pas fixe (P) prédéterminé est sensiblement égal à une longueur d'onde d'émission de la couche électroluminescente (41).

11. Procédé de fabrication selon la revendication 10, dans lequel la couche primaire (22) déposée lors de l'étape de dépôt initial (E2) comprend une résine (24), l'étape de formation de motifs en relief (E3) comprenant alors :

   - une étape d'insolation (E31), dans laquelle ladite résine (24) est insolée à travers un masque d'insolation, et
   - une étape de développement (E32), dans laquelle les portions (23) de la couche primaire (22) sont retirées par développement dans un solvant de développement pour former par complémentarité les motifs en relief (21).

12. Procédé de fabrication selon la revendication 10, dans lequel l'étape de dépôt initial (E2) comprend le dépôt d'une couche isolante intercalaire (26) sur l'électrode de commande (5) puis d'une résine (24) sur la couche isolante intercalaire (26), l'étape de formation de motifs en relief (E3) comprenant alors :

   - une étape d'insolation (E31) dans laquelle ladite résine (24) est insolée à travers un masque d'insolation,
   - une étape de développement (E32) dans laquelle des portions (23) de la résine (24) sont retirées par développement dans un solvant de développement pour former par complémentarité des motifs en relief intermédiaires (25), et
   - une étape de gravure (E34) dans laquelle la résine (24) et la couche isolante intercalaire (26) sont gravées pour former les motifs en relief (21).

13. Procédé de fabrication selon l'une quelconque des revendications 11 ou 12, dans lequel l'étape de formation de motifs en relief (E3) comprend une étape de fluage (E33), mise en oeuvre après l'étape de développement (E32), dans laquelle la résine (24) est soumise à un traitement thermique à une température de fluage, de manière à arrondir les motifs en relief (21) ou les motifs en relief intermédiaires (25).

**Fig. 1**

**Fig. 2**

**Fig. 3**

**Fig. 4**

**Fig. 5**

**Fig. 6**

**Fig. 7**

(E5, E6)

**RAPPORT DE RECHERCHE EUROPEENNE**

Europäisches Patentamt
European Patent Office
Office européen des brevets

Numéro de la demande

EP 25 18 9559

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2014/151651 A1 (JIN SEONG-HYUN [KR] ET AL) 5 juin 2014 (2014-06-05) * alinéas [0066] - [0073]; figures 1-3 * ----- | 1-13 | INV. H10K59/80 H10K50/85 H10K50/818 |
| A | US 2024/204143 A1 (YU JAE CHOUL [KR] ET AL) 20 juin 2024 (2024-06-20) * alinéas [0049], [0050], [0052], [0053], [0054], [0055], [0057], [0068]; figures 1,2 * ----- | 1-13 | H10K50/822 |
| A | US 2015/179978 A1 (SATO TOSHIHIRO [JP]) 25 juin 2015 (2015-06-25) * alinéas [0047], [0071] - [0075]; figure 9 * ----- | 1-13 | |

**DOMAINES TECHNIQUES RECHERCHES (IPC)**

H10K

Le présent rapport a été établi pour toutes les revendications

| Lieu de la recherche | Date d'achèvement de la recherche | Examinateur |
|---|---|---|
| La Haye | 1 décembre 2025 | Faou, Marylène |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.........................................................................
& : membre de la même famille, document correspondant

EPO FORM 1503 03.82 (P04C02)

**EP 4 683 478 A1**

## ANNEXE AU RAPPORT DE RECHERCHE EUROPEENNE
## RELATIF A LA DEMANDE DE BREVET EUROPEEN NO.

EP 25 18 9559

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

01-12-2025

| Document brevet cité au rapport de recherche | Date de publication | Membre(s) de la famille de brevet(s) | Date de publication |
|---|---|---|---|
| US 2014151651 A1 | 05-06-2014 | KR 20140072711 A | 13-06-2014 |
| | | US 2014151651 A1 | 05-06-2014 |
| | | US 2018122879 A1 | 03-05-2018 |
| US 2024204143 A1 | 20-06-2024 | JP 2024086563 A | 27-06-2024 |
| | | KR 20240094912 A | 25-06-2024 |
| | | US 2024204143 A1 | 20-06-2024 |
| US 2015179978 A1 | 25-06-2015 | JP 2015122248 A | 02-07-2015 |
| | | US 2015179978 A1 | 25-06-2015 |

EPO FORM P0460